# EUROPEAN PATENT APPLICATION

(11) **EP 4 818 715 A1**
(43) Date of publication of application: **07.10.2026**
(21) Application number: 24931751.2
(22) Date of filing: 05.07.2024
(51) Int. Cl.: G01R 31/36, G01R 31/382, G01R 31/367, G01R 22/06, H02J 7/00, H02S 40/38

(54) **METHOD AND APPARATUS FOR PROVIDING BATTERY INFORMATION**

(30) Priority: 29.03.2024 KR 20240043733
(71) Applicant: Hanwha Solutions Corporation, Jung-gu Seoul 04541 (KR)
(72) Inventor: KIM, Jae Hwi, Seoul 04541 (KR); KOH, Ga Young, Seoul 04541 (KR)
(74) Representative: Mooser, Sebastian Thomas
(86) International application number: PCT/KR2024/009588
(87) International publication number: WO 2025/206472

(57) **Abstract**

The present disclosure relates to a method and apparatus for providing battery information. The method of providing battery information according to an embodiment of the present disclosure may receive a state of a battery including a current remaining power amount and a specification, may detect first power supplied from a photovoltaic module to the battery and second power supplied from the battery to a load, when the first power is detected, may determine that the battery is being charged, when the second power is detected, may determine that the battery is being discharged, may calculate a remaining power amount of the battery after a preset time based on the state of the battery, the first power, and the second power, and may generate a battery information interface configured to display information about the battery based on the state of the battery and the remaining power amount of the battery after the preset time.

## Description

### Technical Field

The present disclosure relates to a method and apparatus for providing battery information.

### Background Art

photovoltaic power generation is a power generation technology that can produce electricity through a process of collecting energy directly from the sun and converting the collected energy into electricity while generating little pollution. Therefore, photovoltaic power generation is gaining attention as eco-friendly power generation for producing sustainable energy and is growing rapidly.

Meanwhile, most electrical energy production emits greenhouse gases and other air pollutants generated during a process of burning fossil fuels, which is the major cause of climate change and air pollution. Therefore, a consumer culture using electricity efficiently and the consumption of electric energy through self-generation such as photovoltaic power generation may provide many benefits to the environment, economy, and society.

Meanwhile, the spread of photovoltaic power generation systems is increasing to the extent that the photovoltaic power generation systems are installed even in general houses. There may be a need for a technology for easily understanding and managing the operation of photovoltaic power generation systems.

The above-described background technology is technical information that the inventor has possessed for the derivation of the present disclosure or acquired in the derivation process of the present disclosure, and shall not be called a publicly known technology which is published to the general public before the present disclosure is filed.

### Detailed Description of the disclosure

### Technical Problem

The purpose of the present disclosure is to provide a method and apparatus for providing battery information. The objects to be solved by the present disclosure are not limited to the above-described objects, and other objects and advantages of the present disclosure, which are not described above, may be understood by the following description and more clearly understood than the embodiments of the present disclosure. In addition, it will be appreciated that the objects and advantages to be solved by the present disclosure may be realized by means and combinations thereof shown in the claims of the patent.

### Technical Solution to Problem

A first aspect of the present disclosure may provide a method of providing battery information, the method including receiving a state of a battery including a current remaining power amount and a specification, detecting first power supplied from a photovoltaic module to the battery and second power supplied from the battery to a load, when the first power is detected, determining that the battery is being charged, when the second power is detected, determining that the battery is being discharged, calculating a remaining power amount of the battery after a preset time based on the state of the battery, the first power, and the second power, and generating a battery information interface configured to display information about the battery based on the state of the battery and the remaining power amount of the battery after the preset time.

A second aspect of the present disclosure may provide a apparatus for providing battery information, the apparatus including a memory in which at least one program is stored, and a processor which operates by executing the at least one program, wherein the processor receives a state of a battery including a current remaining power amount and a specification, detects first power supplied from a photovoltaic module to the battery and second power supplied from the battery to a load, when the first power is detected, determines that the battery is being charged, when the second power is detected, determines that the battery is being discharged, calculates a remaining power amount of the battery after a preset time based on the state of the battery, the first power, and the second power, and generates a battery information interface configured to display information about the battery based on the state of the battery and the remaining power amount of the battery after the preset time.

A third aspect of the present disclosure may provide a computer-readable recording medium on which a program for executing the method according to the first aspect on a computer is recorded.

In addition, other methods for implementing the present disclosure, other systems, and a computer-readable recording medium on which a computer program for executing the method is stored may be further provided.

Other aspects, features and advantages of the disclosure will become better understood through the accompanying drawings, the claims, and the detailed description.

### Advantageous Effects of the Disclosure

According to various embodiments of the present disclosure, a state of a battery in a photovoltaic power generation system may be intuitively provided to a user.

In addition, according to various embodiments of the present disclosure, additional and detailed information may be provided based on an interactive input of a user.

Furthermore, according to various embodiments of the present disclosure, an expected remaining power amount based on life patterns may be calculated and provided.

### Brief Description of Drawings

FIG. 1 is a conceptual diagram for describing a photovoltaic power generation system according to an embodiment.
FIG. 2 is a schematic diagram illustrating a battery information interface according to an embodiment of the present disclosure.
FIG. 3 is a diagram illustrating a configuration of a remaining amount interface in detail according to an embodiment of the present disclosure.
FIGS. 4A to 4C are diagrams illustrating a remaining amount interface related to charging of a battery according to various embodiments of the present disclosure.
FIGS. 5A and 5B are diagrams illustrating a remaining amount interface related to discharging of a battery according to various embodiments of the present disclosure.
FIGS. 6A to 6C are diagrams illustrating a remaining amount interface related to charging and discharging of a battery according to various embodiments of the present disclosure.
FIG. 7 is a diagram illustrating a remaining amount interface that includes information about a patter-based expected remaining power amount according to an embodiment of the present disclosure.
FIGS. 8A and 8B are diagrams for describing a process in which a user interacts to query detailed information.
FIG. 9 is a flowchart of a method of providing battery information according to an embodiment of the present disclosure.
FIG. 10 is a block diagram of a apparatus for providing battery information according to an embodiment of the present disclosure.

### Best Mode

A method of providing battery information according to an embodiment of the present disclosure may receive a state of a battery including a current remaining power amount and a specification, may detect first power supplied from a photovoltaic module to the battery and second power supplied from the battery to a load, when the first power is detected, may determine that the battery is being charged, when the second power is detected, may determine that the battery is being discharged, may calculate a remaining power amount of the battery after a preset time based on the state of the battery, the first power, and the second power, and may generate a battery information interface configured to display information about the battery based on the state of the battery and the remaining power amount of the battery after the preset time.

### Mode of Disclosure

The advantages and features of the present disclosure and methods of accomplishing the same will become apparent from the embodiments described in detail, taken in conjunction with the accompanying drawings. However, it should be understood that the present disclosure is not limited to the embodiments presented below, but may be implemented in various other forms and includes all transformations, equivalents, and substitutes included in the spirit and scope of the present disclosure. The embodiments presented below are provided so that this disclosure will be complete and will fully convey the scope of the invention to those skilled in the art. In describing the disclosure, when it is determined that the specific description of the known related art unnecessarily obscures the gist of the disclosure, the detailed description thereof will be omitted.

The terms used herein are merely used to describe specific embodiments and are not intended to limit the preset disclosure. An expression used in the singular encompasses the expression of the plural, unless it has a clearly different meaning in the context. In the present application, the word "comprise" or "has" is used to specify existence of a feature, a numbers, a process, an operation, a constituent element, a part, or a combination thereof, and it will be understood that existence or additional possibility of one or more other features or numbers, processes, operations, constituent elements, parts, or combinations thereof are not excluded in advance.

Some embodiments of the present disclosure may be represented by functional block configurations and various processing operations. Some or all of the functional blocks may be implemented in various numbers of hardware and/or software configurations that perform particular functions. For example, the functional blocks of the present disclosure may be implemented by one or more microprocessors or by circuit configurations for a given function. Also, for example, the functional blocks of the present disclosure may be implemented in various programming or scripting languages. Functional blocks may be implemented as algorithms running on one or more processors. In addition, the present disclosure may adopt the related art for electronic configuration, signal processing, and/or data processing. Terms, such as "mechanism," "element," "means," and "configuration" may be used widely and are not limited to mechanical and physical configurations.

In addition, the connecting lines or connecting members between the components shown in the drawings are merely illustrative of functional connections and/or physical or circuit connections. In a practical apparatus, the connections between the components may be represented by various functional connections, physical connections, or circuit connections that may be replaced or added.

Hereinafter, the present disclosure will be described in detail with reference to the accompanying drawings.

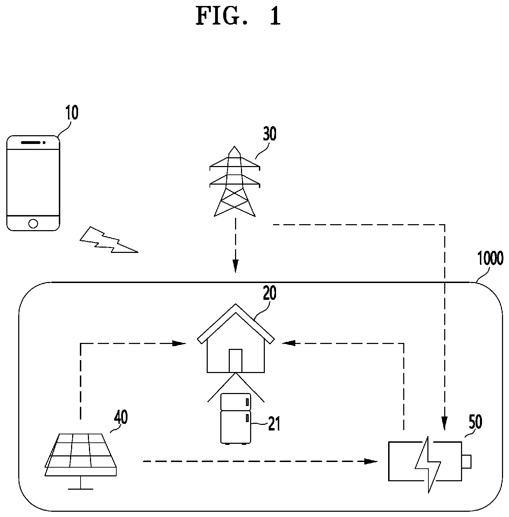

FIG. 1 is a conceptual diagram for describing a photovoltaic power generation system according to an embodiment.

Referring to FIG. 1, a user terminal 10 may include a smartphone, a smart pad, and/or a tablet personal computer (PC). The user terminal 10 may include PCs such as a desktop and a laptop. The user terminal 10 may include smart accessories such as a smartwatch and/or a head-mounted device (HMD), but one or more embodiments are not limited thereto.

The user terminal 10 may control the photovoltaic power generation system 1000. For example, the photovoltaic power generation system 1000 may include at least one photovoltaic module (PV module) 40, a battery 50, and a load 20, but one or more embodiments are not limited thereto. The PV module 40 refers to a device that produces power through sun light. In addition, the battery 50 refers to a device that stores power produced by the PV module 40. Furthermore, the load 20 refers to a place including an object 21 that consumes power.

The photovoltaic power generation system 1000 may receive power from a grid 30. The grid 30 refers to an infrastructure that receives power produced through photovoltaic power generation or supplies power to the load 20 when power produced through the photovoltaic power generation is insufficient.

The user terminal 10 may manage and control a power path through which power is supplied or moved in the photovoltaic power generation system 1000. For example, the power path may include a first path through which power is supplied from the PV module 40 to the battery 50, a second path through which power is supplied from the PV module 40 to the load 20, a third path through which power is supplied from the battery 50 to the load 20, a fourth path through which power is supplied from the grid 30 to the load 20, a fifth path through which power is supplied from the grid 30 to the battery 50, and a sixth path through which power is supplied from the PV module 40 to the grid, but one or more embodiments are not limited thereto.

In the present disclosure, a apparatus for providing battery information may provide information about the battery 50 based on information about on power generation and power consumption in each component included in the photovoltaic power generation system 1000 and a power transfer relationship between respective components. The apparatus for providing battery information of the present disclosure may be the user terminal 10 or may be included in the user terminal 10. Accordingly, a method of providing battery information to be described below may be understood as being performed by the user terminal 10.

Hereinafter, embodiments of various operations of the apparatus for providing battery information of the present disclosure will be described.

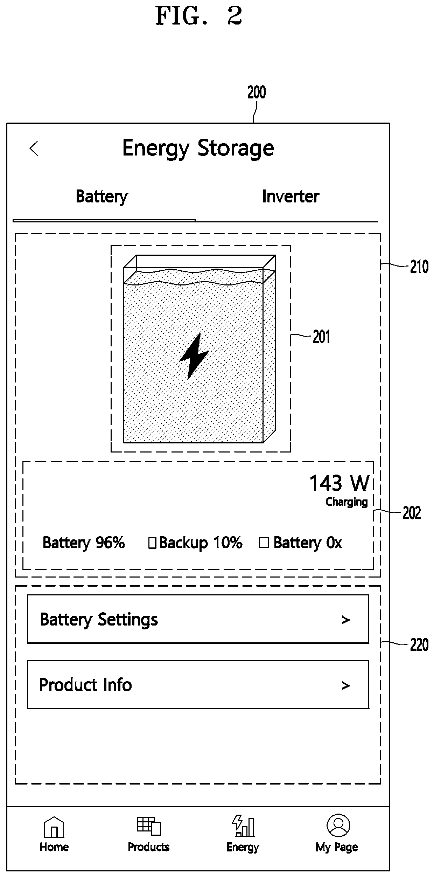

FIG. 2 is a schematic diagram illustrating a battery information interface according to an embodiment of the present disclosure.

In the present disclosure, a battery information interface 200 may be an interface configured to display information about a battery 50. In the present disclosure, the apparatus for providing battery information, that is, a user terminal 10, may generate the battery information interface 200 to display the battery information interface 200 on an output interface of the apparatus for providing battery information.

The apparatus for providing battery information of the present disclosure may detect power related to the battery 50, may calculate various numerical values based on a state of the battery and the power related to the battery 50, and may generate the battery information interface 200 based on the calculated various numerical values.

In an embodiment, the battery information interface 200 may include a first interface 210 configured to allow a current state of the battery 50 to be checked in various aspects and a second interface 220 configured to allow a user to interact to change a setting of the battery 50 or query detailed information about the battery 50.

In an embodiment, the first interface 210 may include a remaining amount interface 201.

In the present disclosure, the remaining amount interface 201 may be an interface that visually represents a remaining power amount of the battery 50. The remaining amount interface 201 of the present disclosure will be described in detail below.

In an embodiment, the first interface 210 may include an interface 202 that displays information about a remaining power amount of the battery 50 as a numerical value.

In an embodiment, information displayed by the interface 202, which displays the information about the remaining power amount of the battery 50 as the numerical value, may be related to a current state of the battery 50, that is, may be real-time information of the battery 50. In an embodiment, the interface 202, which displays the information about the remaining power amount of the battery 50 as the numerical value, may further include a text through which a user may know that the battery 50 is being charged when the battery 50 is being charged. In an embodiment, the interface 202, which displays the information about the remaining power amount of the battery 50 as the numerical value, may further include a value about a minimum charge amount (backup SoC) of the battery 50.

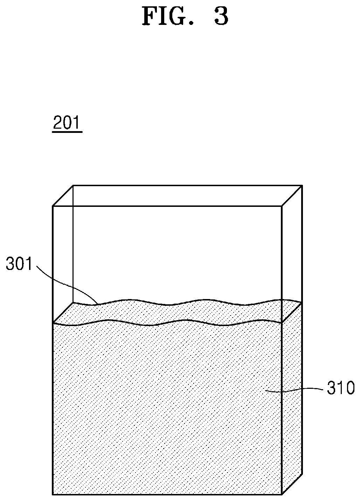

FIG. 3 is a diagram illustrating a configuration of a remaining amount interface in detail according to an embodiment of the present disclosure.

A remaining amount interface 201 shown in FIG. 3 may be the remaining amount interface 201 included in the first interface 210 of FIG. 2. As described above, the remaining amount interface 201 of the present disclosure may visually represent a remaining power amount of a battery 50.

In an embodiment, the remaining amount interface 201 may include a battery shape interface.

In the present disclosure, the battery shape interface may include a shape of the battery 50 such that a user may know that information about the battery 50 is being provided to the user.

Although the battery shape interface expresses the battery 50 in a rectangular parallelepiped shape in FIG. 3, the battery shape interface may express the battery 50 in any suitable shape. For example, the shape of the battery 50 may be any suitable shape such as a cylindrical shape or a spherical shape.

In an embodiment, the remaining amount interface 201 may include a volume interface 310.

In an embodiment, the volume interface 310 may be an interface that occupies a battery shape interface in a shape of a liquid. That is, the volume interface 310 may be expressed as a liquid filling a shape corresponding to the battery 50.

In the present disclosure, the volume interface 310 may indicate a remaining power amount of the battery 50.

The apparatus for providing battery information of the present disclosure may generate the volume interface 310 based on a state of the battery 50. Here, the state of the battery 50 may include a current remaining power amount of the battery 50 and a specification of the battery 50. Even when values of the remaining power amount of the battery 50 are the same, the volume interface 310 may be generated differently according to the total capacity of the battery 50.

In an embodiment, the liquid of the volume interface 310 may have one color. For example, the liquid of the volume interface 310 may have any color such as a gray color, a blue color, a red color, or a green color. In an embodiment, the color of the volume interface 310 may be set by a user. Meanwhile, as will be described below, the color of the liquid in the volume interface 310 may vary according to a charging or discharging state of the battery 50.

In an embodiment, the volume interface 310 may include a water surface object 301 corresponding to a remaining power amount. That is, the volume interface 310 may include an occupation volume occupying the battery shape interface and the water surface object 301 corresponding to the remaining power amount.

In an embodiment, the water surface object 301 may have a shape of a wave. In an embodiment, the water surface object 301 may have a shape of a continuously vibrating wave. That is, the water surface object 301 may be an image consisting of a plurality of frames rather than a single frame image.

In an embodiment, a wave of the water surface object 301 may vibrate according to a preset frequency. In an embodiment, a frequency at which the wave of the water surface object 301 vibrates may vary according to a state of the battery 50. For example, as a charging speed of the battery 50 becomes higher, a frequency may become higher. For example, as a discharging speed of the battery 50 becomes higher, a frequency may become lower.

In an embodiment, the volume interface 310 may indicate a current remaining power amount of the battery 50. That is, the water surface object 301 may correspond to the current remaining power amount, and the current remaining power amount may be expressed as a height of the water surface object 301.

Meanwhile, the apparatus for providing battery information of the present disclosure may detect power supplied to the battery 50 and power supplied from the battery 50.

Specifically, the apparatus for providing battery information may detect power supplied from a PV module 40 to the battery 50 and may detect power supplied from the battery 50 to a load 20. The power supplied from the PV module 40 to the battery 50 may be related to the charging of the battery 50, and the power supplied from the battery 50 to the load 20 may be related to the discharging of the battery 50. That is, the fact that the power supplied from the PV module 40 to the battery 50 has a positive value indicates that the battery 50 is being charged, and the fact that the power supplied from the battery 50 to the load 20 has a positive value may indicate that the battery 50 is being discharged. Both the power supplied from the PV module 40 to the battery 50 and the power supplied from the battery 50 to the load 20 may have positive values.

The apparatus for providing battery information of the present disclosure may generate a battery information interface, specifically, a remaining amount interface, based on power supplied to the battery 50 and power supplied from the battery 50.

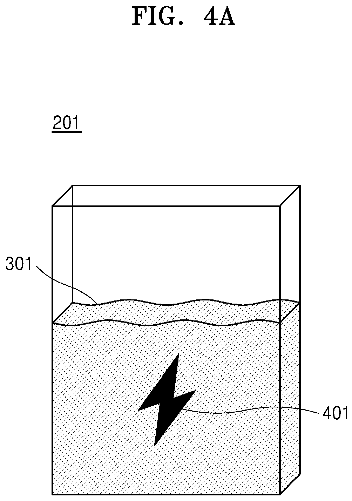

FIGS. 4A to 4C are diagrams illustrating a remaining amount interface related to charging of a battery according to various embodiments of the present disclosure.

A remaining amount interface 201 shown in FIGS. 4A to 4C may be a remaining amount interface 201 that may be generated when a battery 50 is in a state of being charged in a photovoltaic power generation system 1000. That is, when power supplied to the battery 50 has a positive value, the apparatus for providing battery information may generate the remaining amount interface 201 shown in FIGS. 4A to 4C.

Referring to FIG. 4A, the remaining amount interface 201 may further include a first charging object 401 in addition to a water surface object 301.

In an embodiment, the first charging object 401 may be an object indicating that the battery 50 is being charged. As shown in FIG. 4A, the first charging object 401 may be displayed on a surface of a front side of a shape of a battery shape interface. The first charging object 401 may be displayed on a surface of any side other than the front side of the shape of the battery shape interface.

Although, in the example of FIG. 4A, the first charging object 401 has a shape of a lightning bolt, the first charging object 401 may have any suitable shape. For example, the first charging object 401 may have a shape of an electric wire cord or the like.

In the example of FIG. 4A, a user may obtain information about a current remaining power amount through the water surface object 301 of the remaining amount interface 201 and may know that the battery 50 is being charged through the first charging object 401.

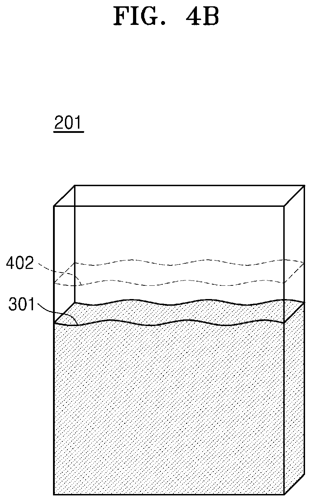

Referring to FIG. 4B, the remaining amount interface 201 may further include a water surface object 402 in addition to the water surface object 301.

In an embodiment, the water surface object 402 may be an object indicating that battery 50 is being charged. As shown in FIG. 4B, a height of the water surface object 402 is greater than a height of the water surface object 301.

In an embodiment, the water surface object 402 may correspond to a remaining power amount after a preset time. The apparatus for providing battery information may calculate the remaining power amount after the preset time based on a state of the battery 50 and power supplied to the battery 50 and may generate the water surface object 402 having a height corresponding to the remaining power amount after the preset time. The preset time may be any suitable time, such as 1 hour or 2 hours, and in an embodiment, the preset time may be set by a user.

In an embodiment, the water surface object 402 may have a shape of a wave like the water surface object 301 and may be an image consisting of a plurality of frames, and the wave of the water surface object 402 may vibrate according to a preset frequency.

In an embodiment, the water surface object 402 may be generated to be visually distinguishable from the water surface object 301. For example, a color of the water surface object 402 may be different from a color of the water surface object 301. For example, a shape of a line of the water surface object 402 may be different from a shape of a line of the water surface object 301.

In the example of FIG. 4B, a user may obtain information about a current remaining power amount through the water surface object 301 of the remaining amount interface 201 and may obtain information about the battery 50 being charged and a remaining power amount after a preset time through the water surface object 402.

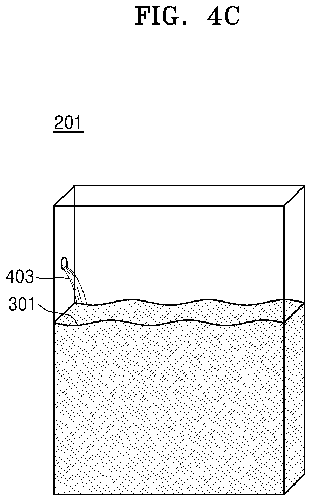

In the example of FIG. 4C, the remaining amount interface 201 may further include a second charging object 403 in addition to the water surface object 301.

In an embodiment, the second charging object 403 may be an object indicating that the battery 50 is being charged. As shown in FIG. 4C, the second charging object 403 may be displayed on a surface of a side of a shape of a battery shape interface. The second charging object 403 may be displayed on a surface of any side other than the side of the shape of the battery shape interface.

In an embodiment, the second charging object 403 may have a shape that supplies a liquid to the battery shape interface. That is, the second charging object 403 may have a shape of a pouring liquid and a shape of a hole through which the liquid pours.

In an embodiment, the second charging object 403 may vary according to a charging speed of the battery 50. For example, when the charging speed of the battery 50 is high, an amount of pouring liquid expressed through the second charging object 403 may increase.

In the example of FIG. 4C, a user may obtain information about a current remaining power amount through the water surface object 301 of the remaining amount interface 201 and may obtain information about the battery 50 being charged and a charging speed through the second charging object 403.

In addition, an object or interface through a user may know that the battery 50 is in a state of being charged may be displayed on the remaining amount interface 201.

For example, when the battery 50 is charged, a color of the volume interface 310 of the remaining amount interface 201 may change. For example, the color of the volume interface 310 may change from a green color to a yellow color.

For example, when the battery 50 is charged, a frequency at which the wave of the water surface object 301 vibrates may increase. For example, the frequency at which the wave vibrate may become higher as the charging speed becomes higher.

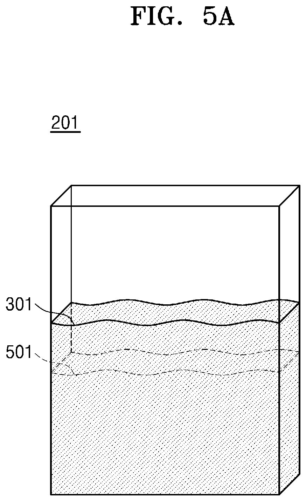

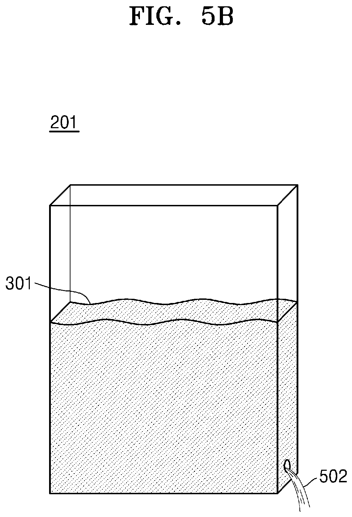

FIGS. 5A and 5B are diagrams illustrating a remaining amount interface related to discharging of a battery according to various embodiments of the present disclosure.

A remaining amount interface 201 shown in FIGS. 5A and 5B may be a remaining amount interface 201 that may be generated when a battery 50 is in a state of being discharged in a photovoltaic power generation system 1000. That is, when power supplied from the battery 50 has a positive value, the apparatus for providing battery information may generate the remaining amount interface 201 shown in FIGS. 5A and 5B.

Referring to FIG. 5A, the remaining amount interface 201 may further include a water surface object 501 in addition to a water surface object 301.

In an embodiment, the water surface object 501 may be an object indicating that the battery 50 is being discharged. As shown in FIG. 5A, a height of the water surface object 501 is less than a height of the water surface object 301.

In an embodiment, the water surface object 501 may correspond to a remaining power amount after a preset time. The apparatus for providing battery information may calculate the remaining power amount after the preset time based on a state of the battery 50 and power supplied to the battery 50 and may generate the water surface object 501 having a height corresponding to the remaining power amount after the preset time. The preset time may be any suitable time, such as 1 hour or 2 hours, and in an embodiment, the preset time may be set by a user.

In an embodiment, the water surface object 501 may have a shape of a wave like the water surface object 301 and may be an image consisting of a plurality of frames, and the wave of the water surface object 501 may vibrate according to a preset frequency.

In the example of FIG. 5B, a user may obtain information about a current remaining power amount through the water surface object 301 of the remaining amount interface 201 and may obtain information about the battery 50 being discharged and a remaining power amount after a preset time through the water surface object 501.

In the example of FIG. 5B, the remaining amount interface 201 may further include a discharging object 502 in addition to the water surface object 301.

In an embodiment, the discharging object 502 may be an object indicating that the battery 50 is being discharged. As shown in FIG. 5B, the discharging object 502 may be displayed on a surface of a side of a shape of a battery shape interface. The discharging object 502 may be displayed on a surface of any side other than the side of the shape of the battery shape interface.

In an embodiment, the discharging object 502 may have a shape in which a liquid of the battery shape interface pours outward. That is, the discharging object 502 may have a shape of a pouring liquid and a shape of a hole through which the liquid pours.

In an embodiment, the discharging object 502 may vary according to a charging speed of the battery 50. For example, when the charging speed of the battery 50 is high, an amount of pouring liquid expressed through the discharging object 502 may increase.

In the example of FIG. 5B, a user may obtain information about a current remaining power amount through the water surface object 301 of the remaining amount interface 201 and may obtain information about the battery 50 being discharged and a charging speed through the discharging object 502.

In addition, an object or interface through which a user may know that the battery 50 is in a state of being discharged may be displayed on the remaining amount interface 201.

For example, when the battery 50 is discharged, a color of a volume interface 310 of the remaining amount interface 201 may change. For example, the color of the volume interface 310 may change from a green color to a red color.

For example, when the battery 50 is discharged, a frequency at which the wave of the water surface object 301 vibrates may decrease. For example, the frequency at which the wave vibrate may become lower as a discharging speed becomes higher.

Meanwhile, as described above, both power supplied from a PV module 40 to the battery 50 and power supplied from the battery 50 to a load 20 may have positive values. In this case, the battery 50 may be charged and discharged at the same time. In this case, the apparatus for providing battery information may may generate a battery information interface by combining the above-described embodiments.

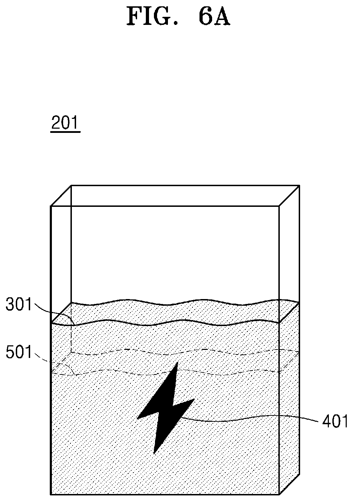

FIGS. 6A to 6C are diagrams illustrating a remaining amount interface related to charging and discharging of a battery according to various embodiments of the present disclosure.

A remaining amount interface 201 shown in FIGS. 6A to 6C may be a remaining amount interface 201 that may be generated when a battery 50 is in a state of being charged and discharged in a photovoltaic power generation system 1000. That is, when power supplied to the battery 50 and power supplied from the battery 50 have positive values, the apparatus for providing battery information may generate the remaining amount interface 201 shown in FIGS. 6A to 6C.

Referring to FIG. 6A, the remaining amount interface 201 may include a water surface object 301, a first charging object 401, and a water surface object 501.

Since the first charging object 401 and the water surface object 501 have been described above, detailed descriptions thereof will be omitted.

Meanwhile, the water surface object 501 may be generated in consideration of both power supplied to the battery 50 and power supplied from the battery 50. That is, the example shown in FIG. 6A may correspond to a case in which the battery 50 is being charged, but an amount of discharge is greater than that of the charge, that is, a case in which power supplied from the battery 50 is greater than power supplied to the battery 50.

Therefore, when the battery 50 is being discharged, but an amount of charge is greater than that of the discharge, that is, when power supplied to the battery 50 is greater than power supplied from the battery 50, the remaining amount interface 201 may include a water surface object 402 rather than the water surface object 501.

In the example of FIG. 6A, a user may obtain information about a current remaining power amount through the water surface object 301 of the remaining amount interface 201 and may obtain information through the first charging object 401, wherein the information indicates that the battery 50 is being charged, but since power contributing to discharge is greater as compared to the charge, a remaining power amount will decrease after a preset time.

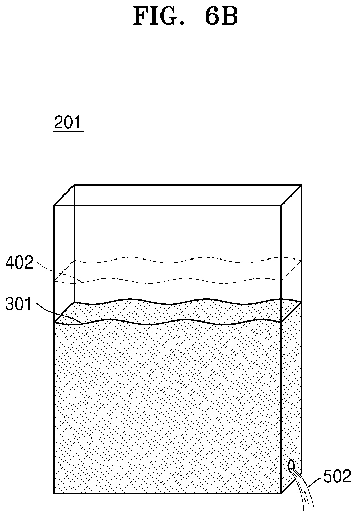

Referring to FIG. 6B, the remaining amount interface 201 may include a water surface object 301, a water surface object 402, and a discharging object 502.

Since the water surface object 402 and the discharging object 502 have been described above, detailed descriptions thereof will be omitted.

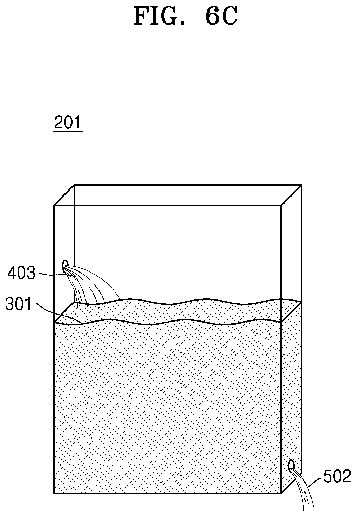

Meanwhile, similarly, in the example of FIG. 6, when, although the water surface object 402, which has a height that is greater than a height of the water surface object 301, is included in the remaining amount interface 201, the battery 50 is being charged, but an amount of discharge is greater than that of the charge, the remaining amount interface 201 may include a water surface object 501 rather than the water surface object 402.

In the example of FIG. 6B, a user may obtain information about a current remaining power amount through the water surface object 301 of the remaining amount interface 201, may obtain information about the battery 50 being charged and a remaining power amount after a preset time through the water surface object 402, may obtain information about the battery 50 being discharged and a discharging speed through the discharging object 502, and may obtain information indicating that the battery 50 is being discharged, but since power contributing to charge is greater as compared to the discharge, a remaining power amount will increase after a preset time.

Referring to FIG. 6C, the remaining amount interface 201 may include a water surface object 301, a second charging object 403, and a discharging object 502.

Since the second charging object 403 has been described above, detailed descriptions thereof will be omitted.

As described above, in an embodiment, the second charging object 403 may vary according to a charging speed, and the discharging object 502 may vary according to a discharging speed. Referring to FIG. 6C, an amount of pouring liquid expressed through the second charging object 403 is greater than an amount of pouring liquid expressed through the discharging object 502. This may mean that a charging speed of the battery 50 is greater than a discharging speed thereof.

In the example of FIG. 6C, a user may obtain information about a current remaining power amount through the water surface object 301 of the remaining amount interface 201 and may obtain information through the second charging object 403, wherein the information indicates that although the battery 50 is being charged and discharged at the same time and the discharging object 502, a charging speed is greater than a discharging speed.

In addition, the apparatus for providing battery information may generate a battery information interface by combining embodiments in a different way.

For example, the remaining amount interface 201 shown in FIG. 6C may further include a water surface object 402. For example, when a charging speed of the battery 50 is greater than a discharging speed thereof, a color of a volume interface 310 may be a yellow color, and in the opposite case, the color of the volume interface 310 may be a red case. For example, the remaining amount interface 201 of FIGS. 6A to 6C may include the water surface object 301 with a high frequency wave when a charging speed is high.

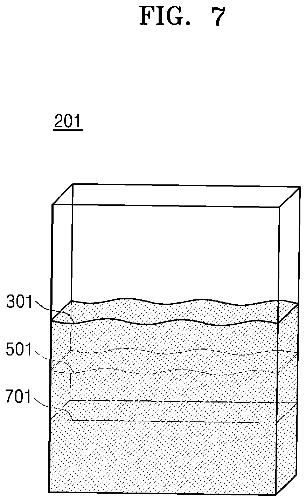

FIG. 7 is a diagram illustrating a remaining amount interface that includes information about a pattern-based expected remaining power amount according to an embodiment of the present disclosure.

The apparatus for providing battery information of the present disclosure may calculate a power pattern of a battery 50. There may be a pattern in daily life of a user, and through the pattern in the daily life of the user, a supply, movement, and consumption pattern of power may be generated in a photovoltaic power generation system 1000. The supply, movement, and consumption pattern of the power in the photovoltaic power generation system 1000 may be expressed as a pattern related to an increase or decrease in power of a battery 50, and the pattern related to the increase or decrease in power of the battery 50 may be referred to as a pattern related to a power pattern of the battery 50.

The apparatus for providing battery information of the present disclosure may record and store data about an increase or decrease in power of the battery 50 in the photovoltaic power generation system 1000 and may calculate a power pattern through the data about the increase or decrease in power.

In an embodiment, the power pattern may be calculated based on various patterning factors.

For example, the patterning factor may be a date. That is, data about an increase or decrease in power may be categorized based on a date. Users may conduct their daily lives based on patterns according to a date, and accordingly, a power consumption pattern according to a date may be generated.

For example, the patterning factor may be a climate. That is, data about increase or decrease in power may be categorized based on the climate. Here, the climate may include temperature, humidity, precipitation, or the like. Users may conduct their daily lives based on a pattern according to the climate, and a pattern may be formed in the supply of power from a PV module 40 or a grid 30 according to the climate. Accordingly, a supply and consumption pattern of power according the climate may be generated.

In addition, the supply and consumption pattern of power may be generated based on various patterning factors, one or more patterning factors may be combined, and the apparatus for providing battery information may calculate a power pattern of the battery 50 based on the supply and consumption pattern of the power.

In an embodiment, the apparatus for providing battery information may calculate a pattern-based expected remaining power amount based on a current remaining power amount and the power pattern of the battery 50.

In an embodiment, the pattern-based expected remaining power amount may be calculated based on a preset time. For example, the preset time may be any suitable time such as midnight or 6 a.m., and the preset time may be set by a user.

In an embodiment, the apparatus for providing battery information may include an artificial intelligence learning and inference model, and the artificial intelligence learning and inference model may be a model that is trained to receive patterning factors such as a date and a climate as input data and output data about an expected battery power increase or decrease as output data. The apparatus for providing battery information may calculate the pattern-based expected remaining power amount based on the output data about the expected battery power increase or decrease.

In an embodiment, the apparatus for providing battery information may generate a battery information interface, specifically, a remaining amount interface 201, based on the calculated pattern-based expected remaining power amount.

Referring to FIG. 7, the remaining amount interface 201 may further include a water surface object 701 as compared to the remaining amount interface 201 of FIG. 5A. That is, the remaining amount interface 201 of FIG. 7 may include a water surface object 301, a water surface object 501, and the water surface object 701.

Since the water surface object 301 and the water surface object 501 have been described above, detailed descriptions thereof will be omitted.

In an embodiment, the water surface object 701 may correspond to a pattern-based expected remaining power amount. In an embodiment, the water surface object 701 may correspond to an expected remaining power amount based on a preset time.

In an embodiment, the water surface object 701 may be provided differently from the water surface object 301 and the water surface object 501 to be visually distinguishable therefrom. For example, the water surface object 301 and the water surface object 501 may have a shape of a wave, but the water surface object 701 may not have a shape of a wave. For example, the water surface object 701 may consist of lines having a different shape from the water surface object 301 and the water surface object 501. In addition, the water surface object 701 may be provided differently from other water surface objects such that a user may know that the water surface object 701 shows information having a different nature from other water surface objects.

In the example of FIG. 7, a user may obtain information about a current remaining power amount through the water surface object 301 of the remaining amount interface 201, may obtain information about the battery 50 being discharged and a remaining power amount after a preset time through the water surface object 501, and may obtain information about an expected remaining power amount at a preset time calculated according to a power pattern of the battery 50 through the water surface object 701. When the expected remaining power amount at the preset time is expected to increase according to the power pattern of the battery 50, it may be easily understood that there may be a case in which a height of the water surface object 701 is greater than a height of the water surface object 301.

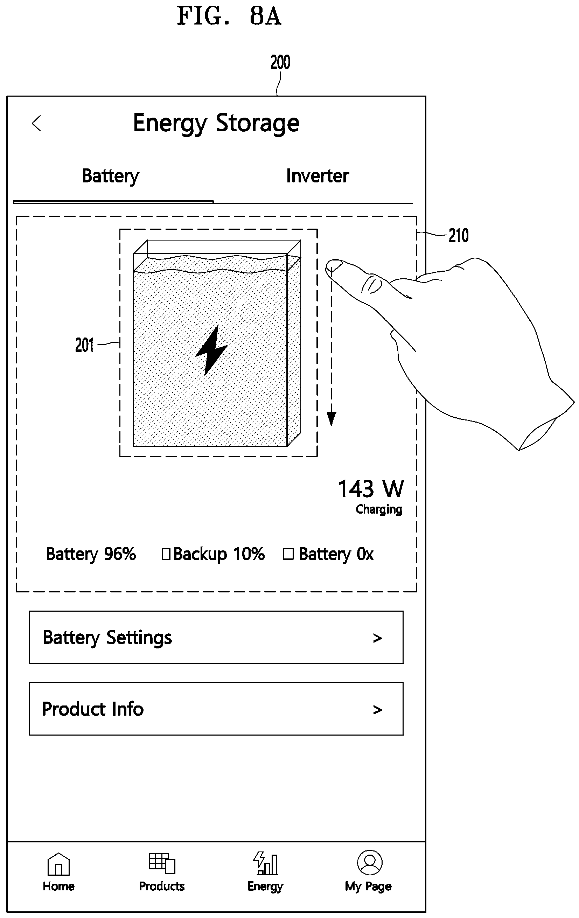

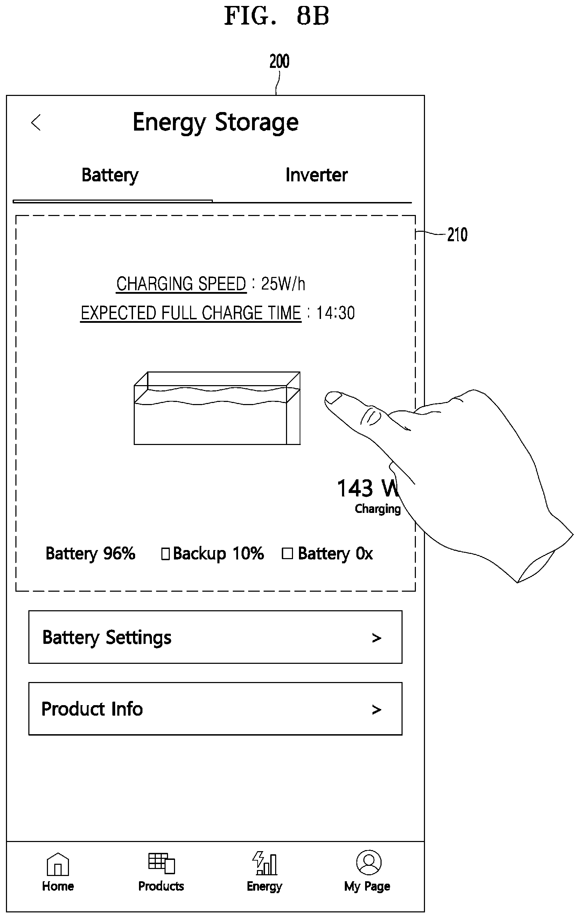

FIGS. 8A and 8B are diagrams for describing a process in which a user interacts to query detailed information.

In an embodiment, a battery information interface 200 may be provided such that a user may interact therewith, and the user may interact with the battery information interface 200 to query detailed information about charging and discharging of a battery 50. In an embodiment, the user may interact with a remaining amount interface 201 in a first interface 210 to query detailed information. That is, the apparatus for providing battery information may receive an interactive input of the user and may display detailed information about the battery 50 based on the interactive input of the user.

FIGS. 8A and 8B illustrate examples of detailed information about a battery generated and provided by the apparatus for providing battery information according to an interaction of a user.

Referring to FIG. 8A, FIG. 8A illustrates that the user interact to touch and scroll a portion of the first interface 210 in the battery information interface 200 and swipe down on the battery information interface 200.

Referring to FIG. 8B, FIG. 8B illustrates that as the user interacts to touch and scroll a portion of the first interface 210 and swipe down the remaining amount interface 201, information related to charging of the battery 50 is displayed.

That is, the apparatus for providing battery information may display information related to the charging of the battery 50 in response to the interaction with the first interface 210, specifically, reception of a downward touch and scroll input.

Although not shown, in an embodiment, when the user interacts to touch and scroll a portion of the first interface 210 in the battery information interface 200 and swipe up on the remaining amount interface 201, information related to discharging of the battery 50 may be displayed.

That is, the apparatus for providing battery information may display information related to the discharging of the battery 50 in response to the interaction with the first interface 210, specifically, reception of an upward touch and scroll input.

In addition, the apparatus for providing battery information may display detailed information in response to reception of an interactive input of a user through various methods.

In an embodiment, the user may interact with a first charging object 401, a water surface object 402, or a second charging object 403 in the remaining amount interface 201, and the apparatus for providing battery information may display information related to charging of the battery 50 in response to reception of an input for interacting with the first charging object 401, the water surface object 402, or the second charging object 403. Here, the interaction of the user may be a touch input.

In an embodiment, the user may interact with a water surface object 501 or a discharging object 502 in the remaining amount interface 201, and the apparatus for providing battery information may may display information related to discharging of the battery 50 in response to a reception of an input interacting with the water surface object 501 or the discharging object 502. Here, the interaction of the user may be a touch input.

In an embodiment, a user may interact with a water surface object 701 in the remaining amount interface 201, and the apparatus for providing battery information may display information about of a pattern-based expected remaining power amount of the battery 50 in response to reception of an input for interacting with the water surface object 701. Here, the interaction of the user may be a touch input.

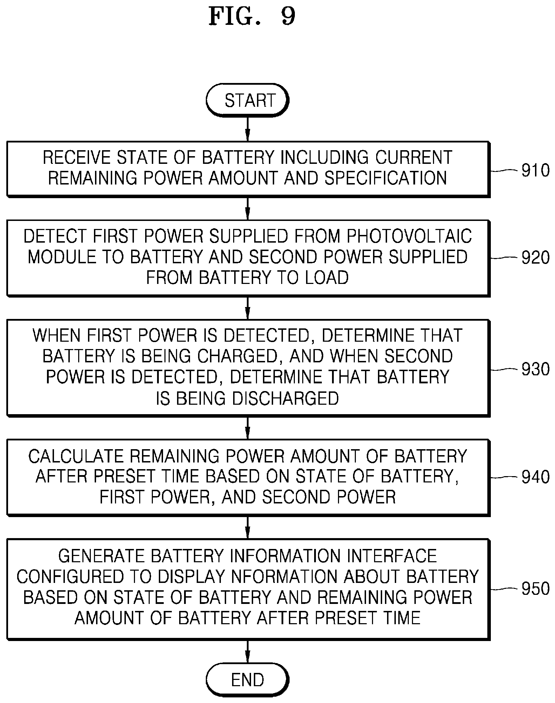

FIG. 9 is a flowchart of a method of providing battery information according to an embodiment of the present disclosure.

Each of operations of the method of providing battery information to be described below may be performed by the above-described apparatus for providing battery information, and specifically, may be performed by a processor included in the above-described apparatus for providing battery information.

In operation 910, the processor may receive a state of a battery including a current remaining power amount and a specification.

In operation 920, first power supplied from a PV module to the battery and second power supplied from the battery to a load may be detected.

In operation 930, when the first power is detected, it may be determined that the battery is being charged, and when the second power is detected, it may be determined that the battery is being discharged.

In operation 940, a remaining power amount of the battery after a preset time may be calculated based on the state of the battery, the first power, and the second power.

In operation 950, a battery information interface configured to display information about the battery based on the state of the battery and the remaining power amount of the battery after the preset time may be generated.

In an embodiment, the battery information interface may include a remaining amount interface that visually represents the remaining power amount of the battery.

In an embodiment, the remaining amount interface may include a battery shape interface and a volume interface indicating a current remaining power amount.

In an embodiment, the volume interface may include an occupation volume occupying the battery shape interface in a shape of a liquid and a first water surface object corresponding to the current remaining power amount.

In an embodiment, the volume interface may include a second water surface object corresponding to the remaining power amount after the preset time.

In an embodiment, the first water surface object and the second water surface object may be generated to be visually distinguishable from each other.

In an embodiment, when the first power has a positive value, the remaining amount interface may further include an object indicating that the battery is being charged.

In an embodiment, when the second power has a positive value, the remaining amount interface may further include an object indicating that the battery is being discharged.

In an embodiment, after operation 950, the processor may display the battery information interface.

In an embodiment, the processor may receive an interactive input of a user on the battery information interface and may display detailed information about charging or discharging of the battery based on the interactive input.

In an embodiment, after operation 950, the processor may calculate a power pattern.

In an embodiment, the processor may calculate a pattern-based expected remaining power amount based on the current remaining power amount and the power pattern.

In an embodiment, the battery information interface may be configured to further display the pattern-based expected remaining power amount.

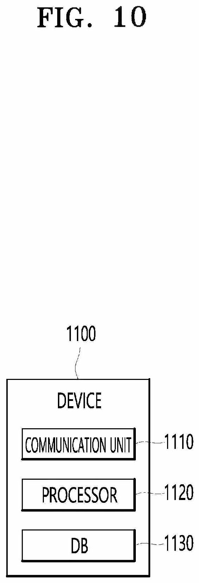

FIG. 10 is a block diagram of a apparatus for providing battery information according to an embodiment of the present disclosure.

As described above, a apparatus 1100 for providing battery information shown in FIG. 10 may be a user terminal 10 or may be included in the user terminal 10.

Referring to FIG. 10, the apparatus 1100 for providing battery information may include a communication unit 1110, a processor 1120, and a database (DB) 1130. In the apparatus 1100 for providing battery information 1100 of FIG. 10, only components related to the embodiment are shown. Accordingly, those skilled in the art may understand that other general-purpose components may be included in addition to the components shown in FIG. 10.

The processor 1120 controls the overall operation of the apparatus 1100 for providing battery information. For example, the processor 1120 may control the overall operations of the DB 1130, the communication unit 1110, an input unit (not shown), and/or an output unit (not shown) by executing programs stored in the DB 1130. The processor 1120 may control the operation of the apparatus 1100 for providing battery information by executing the programs stored in the DB 1130.

The processor 1120 may control at least some of the operations of the apparatus 1100 for providing battery information described above with reference to FIGS. 1 to 9. For example, the processor 1120 may receive a state of a battery, may detect first power supplied from a PV module to the battery and second power supplied from the battery to a load. When the first power is detected, the processor 1120 may determine that the battery is being charged, and when the second power is detected, the processor 1120 may determine that the battery is being discharged. The processor 1120 may calculate a remaining power amount of the battery after a preset time based on the state of the battery, the first power, and the second power and may generate a battery information interface configured to display information about the battery based on the state of the battery and the remaining power amount of the battery after the preset time.

Meanwhile, specific examples in which the processor 1120 operates are the same as those described above with reference to FIGS. 1 to 9. Therefore, detailed descriptions of the operation of the processor 1120 will be omitted below.

The processor 1120 may be implemented using at least one of application specific integrated circuits (ASICs), digital signal processors (DSPs), digital signal processing devices (DSPDs), programmable logic devices (PLDs), field programmable gate arrays (FPGAs), controllers, micro-controllers, microprocessors, and other electrical units for performing functions.

The DB 1130 may be hardware that stores various types of data processed in the apparatus 1100 for providing battery information and may store programs for various operations, processing, and control of the processor 1120.

The DB 1130 may include a random access memory (RAM) such as a dynamic random access memory (DRAM) or a static random access memory (SRAM), a read-only memory (ROM), an electrically erasable programmable read-only memory (EEPROM), a compact disk (CD)-ROM, a Blu-ray or another optical disk storage, a hard disk drive (HDD), a solid state drive (SSD), or a flash memory.

The communication unit 1110 may include at least one component that allows the apparatus 1100 for providing battery information to perform wired/wireless communication with at least a portion of a power system, the user terminal, and/or other external devices. For example, the communication unit 1110 may include a short-range communication unit and/or a mobile communication unit.

Meanwhile, embodiments according to the present disclosure may be implemented in the form of a computer program executable through various components on a computer. Such a computer program may be recorded on a computer readable medium. In this case, media may include magnetic media such as a hard disk, a floppy disk, and a magnetic tape, optical recording media such as a CD-ROM and a digital versatile disk (DVD), magneto-optical media such as a floptical disk, and hardware devices specifically configured to store and execute program commands, such as a ROM, a RAM, and a flash memory.

Meanwhile, the computer program may be components specially designed for the present disclosure or may be usable by a skilled person in a field of computer software. Examples of the computer program may include not only a machine language code made by a complier, but also a high level code that can be used by an interpreter or the like, which is executed by a computer.

According to one embodiment, methods according to various embodiments of the present disclosure may be included and provided in a computer program product. A computer program product may be transacted between a seller and a purchaser as a commodity. The computer program product may be distributed in the form of a machine-readable storage medium (for example, a CD-ROM) or distributed online through an application store (for example, PLAYSTORE^{™}). In the case of online distribution, at least a portion of the computer program product may be at least temporarily stored in a storage medium such as a server of a manufacturer, a server of an application store, or a memory of a relay server or may be temporarily generated.

The operations of all methods described herein may be performed in any suitable order unless otherwise indicated herein or otherwise clearly contradicted by context. The present disclosure is not necessarily limited by the described order of the operations. The use of any and all examples, or exemplary language (for example, "such as") provided herein, is intended merely to describe the present disclosure in detail and does not pose a limitation on the scope of the present disclosure unless otherwise claimed. In addition, those skilled in the art may recognize that various modifications, combinations, and changes may be configured according to design conditions and factors within the scope of the appended claims or equivalents thereof.

Therefore, the spirit of the present disclosure should not be limited to the above-described embodiments, and not only the scope of the appended claims but also all ranges equivalent to or equivalently changed from the claims are within the scope of the present disclosure.

## Claims

1. A method of providing battery information, the method comprising:
receiving a state of a battery comprising a current remaining power amount and a specification;
detecting first power supplied from a photovoltaic module to the battery and second power supplied from the battery to a load;
when the first power is detected, determining that the battery is being charged;
when the second power is detected, determining that the battery is being discharged;
calculating a remaining power amount of the battery after a preset time based on the state of the battery, the first power, and the second power; and
generating a battery information interface configured to display information about the battery based on the state of the battery and
the remaining power amount of the battery after the preset time.

2. The method of claim 1, wherein the battery information interface comprises a remaining amount interface which visually represents the remaining power amount of the battery,
the remaining amount interface comprises a battery shape interface and a volume interface indicating the current remaining power amount, and
the volume interface comprises an occupation volume occupying the battery shape interface in a shape of a liquid and a first water surface object corresponding to the current remaining power amount.

3. The method of claim 2, wherein the volume interface comprises a
second water surface object corresponding to the remaining power amount after the preset time, and
the first water surface object and the second water surface object are generated to be visually distinguishable from each other.

4. The method of claim 2, wherein, when the first power has a positive value, the remaining amount interface further comprises an object indicating that the battery is being charged.

5. The method of claim 2, wherein, when the second power has a positive value, the remaining amount interface further comprises an object indicating that the battery is being discharged.

6. The method of claim 1, further comprising:
displaying the battery information interface;
receiving an interactive input of a user on the battery information interface; and
displaying detailed information about charging or discharging of the battery based on the interactive input.

7. The method of claim 1, further comprising:
calculating a power pattern of the battery; and
calculating a pattern-based expected remaining power amount based on the current remaining power amount and the power pattern,
wherein the battery information interface is configured to further display the pattern-based expected remaining power amount.

8. A apparatus for providing battery information, the apparatus comprising:
a memory in which at least one program is stored; and
a processor which operates by executing the at least one program,
wherein the processor is configured to: receive a state of a battery comprising a current remaining power amount and a specification;
detect first power supplied from a photovoltaic module to the battery and second power supplied from the battery to a load;
when the first power is detected, determine that the battery is being charged, and when the second power is detected,
determine that the battery is being discharged; calculate a remaining power amount of the battery after a preset time based on the state of the battery, the first power, and the second power;
and generate a battery information interface configured to display information about the battery based on the state of the battery and
the remaining power amount of the battery after the preset time.

9. The apparatus of claim 8, wherein the battery information
interface comprises a remaining amount interface which visually represents the remaining power amount of the battery,
the remaining amount interface comprises a battery shape interface and a volume interface indicating the current remaining power amount, and
the volume interface comprises an occupation volume occupying the battery shape interface in a shape of a liquid and a first water surface object corresponding to the current remaining power amount.

10. The apparatus of claim 9, wherein the volume interface comprises
a second water surface object corresponding to the remaining power amount after the preset time, and
the first water surface object and the second water surface object are generated to be visually distinguishable from each other.

11. The apparatus of claim 9, wherein, when the first power has a positive value, the remaining amount interface further comprises an object indicating that the battery is being charged.

12. The apparatus of claim 9, wherein, when the second power has a positive value, the remaining amount interface further comprises an object indicating that the battery is being discharged.

13. The apparatus of claim 8, wherein the processor is further configured to: display the battery information interface; receive an interactive input of a user on the battery information interface; and display detailed information about charging or discharging of the battery based on the interactive input.

14. The apparatus of claim 8, wherein the processor is further
configured to calculate a power pattern of the battery and calculate a pattern-based expected remaining power amount based on the current remaining power amount and the power pattern, and
the battery information interface is configured to further display the pattern-based expected remaining power amount.

15. A computer-readable recording medium having recorded thereon program for causing the method of claim 1 to be executed on a computer.
